# EUROPEAN PATENT APPLICATION

(11) **EP 0 534 676 A2**
(43) Date of publication of application: **31.03.1993**
(21) Application number: 92308471.9
(22) Date of filing: 17.09.1992
(51) Int. Cl.: G11C 16/04, H01L 29/788

(54) **EEPROM with improved endurance properties**

(30) Priority: 25.09.1991 US 765630
(71) Applicant: AT&T Corp., New York, NY 10013-2412 (US)
(72) Inventor: Kohler, Ross Alan, Allentown, Pennsylvania 18104 (US)
(74) Representative: Watts, Christopher Malcolm Kelway, Dr.

(57) **Abstract**

An EEPROM achieves improved endurance in terms of number of write/erase cycles by using separate channels for writing and reading. The separate channels (13,15) have a common floating gate (5).

## Description

### Technical Field

This invention relates to semiconductor devices having floating gates such as the memory devices termed *EEPROMs*.

### Background of the Invention

Many types of semiconductor memories have been developed and are presently used. These memories may be either volatile or nonvolatile, i.e., they either lose or retain, respectively, the stored information when power is removed. One common nonvolatile read only memory (ROM) device is termed an EEPROM which is an acronym for electrically erasable programmable read only memory.

This device, in one basic embodiment, has source/drain regions and an intermediate gate structure which has a floating gate spaced from the channel between the source/drain regions. The floating gate is underneath a read gate. There is a dielectric between the channel and the floating gate. Charge, injected from the substrate, can be stored on the floating gate and its presence or absence changes the electrical transport characteristics between the source/drain regions when a voltage is applied to the read gate. The transport characteristics indicate the state, i.e., logic "0" or " 1 ", of the device. The device may be erased, i.e., the stored charge removed from the gate, by applying an appropriate voltage to transfer the charge from the floating gate to the substrate.

Another embodiment of an EEPROM adds an erase gate to the gate structure just described. This embodiment typically has a split gate structure. The term *split gate* means that the floating gate is over only a portion of the channel extending between source/drain regions. The erase gate removes the trapped charge from the floating gate so that charge is not transferred to the substrate. The erase gate is separated from the floating gate by an insulating material through which the charge moves during erasing.

Although present EEPROMs, such as those briefly described, are adequate for many applications, they have not achieved wider acceptance as a general purpose nonvolatile memory element because they have limited endurance; i.e., they can sustain only a limited number of write-erase cycles before the threshold voltages increases, due to effects such charge trapping and oxide degradation, and the device becomes unusable. The number of write/erase cycles of a typical device is presently about 10,000. See, e.g., the paper by Sweetman, entitled *"Manufacturing Approaches for Endurance,"* presented at the 11th IEEE Non-Volatile Semiconductor Memory Workshop February 19-22, 1991, Monterey, California, for a general discussion of endurance considerations for EEPROMs.

Writing and erasing both involve charge transport caused by high electric fields through a relatively thin dielectric which is freqently an oxide. Effort to increase device endurance have concentrated on the erase oxide in the belief that either trapped electrons in the oxide or interface states are the prime cause of the device degradation which manifested itself in an increase in the erase voltage. The assumption that erase oxide degradation was the primary problem was reasonable because it had been shown to be the limiting factor in EEPROMs with endurance requirements less than 10,000 program/erase cycles.

### Summary of the Invention

An EEPROM has a gate structure having a floating gate, spaced and insulated from the substrate, and separate channels for reading and programming. The point of charge injection into the floating gate is not over the read channel. In one embodiment, the two channels share first and second source/drain regions and the floating gate, but have separate gates for programming and reading which utilize different portions of the area between the first and second source/drain regions for programming and erasing. In another embodiment, the channels share both a program/read gate and a first source/drain region which is between second and third source/drain regions and the first and second channels are between the second and first and first and third regions, respectively. In yet another embodiment, the gate comprises a split gate. And, in yet another embodiment, there is also an erase gate. The characteristics of the read only channel are not degraded by hot carriers injected into the floating gate during programming. Device endurance may exceed 1,000,000 write/erase cycles.

### Background of the Invention

FIG. 1 is a top view of one embodiment of a device according to this invention;
FIG. 2 is a sectional view along line A-A′ of FIG. 1;
FIG. 3 is a top view of another embodiment of a device according to this invention; and,
FIG. 4 is a sectional view along line B-B′ of FIG. 3.

For reasons of clarity, the elements of the devices depicted are not drawn to scale. Identical numerals in different FIGURES represent identical elements.

### Detailed Description

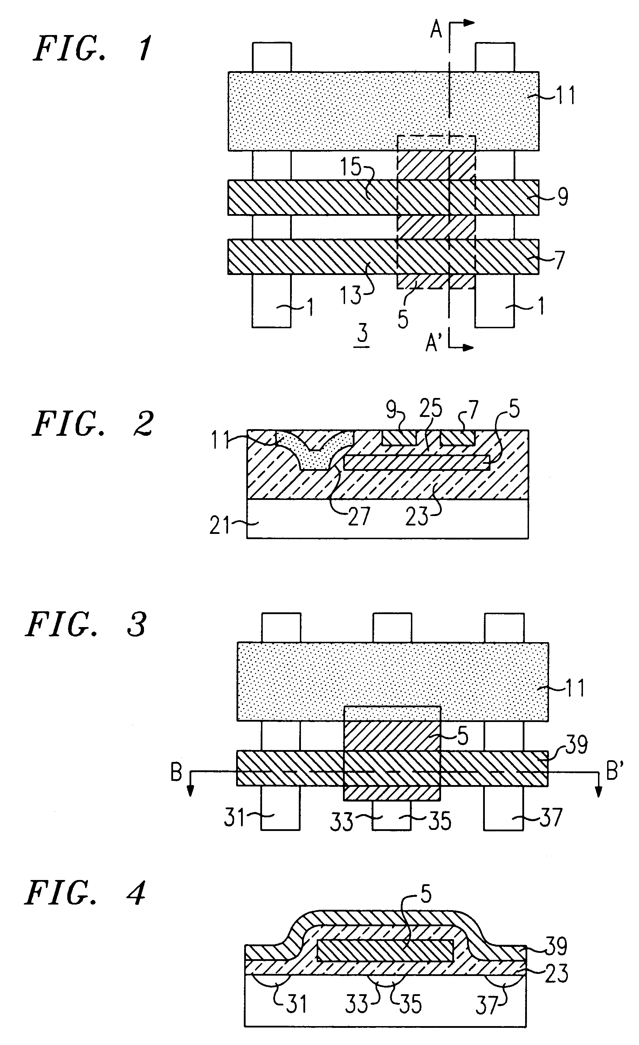

One embodiment of an EEPROM device according to my invention is shown in a top view in FIG. 1. Depicted are source/drain regions 1, channel region 3 between the source/drain regions 1, and a split gate structure which has floating gate 5, read gate 7, program gate 9 and erase gate 11. Floating gate 5 is underneath portions of the read, program and erase gates.

A sectional view along line A-A′ of FIG. 1 is depicted in FIG. 2. In addition to the elements depicted in FIG. 1, substrate 21, and oxide regions 23, 25 and 27 are depicted. The oxide regions specifically mentioned are between the substrate 1 and floating gate, floating gate and the reading and programming gates, and the floating gate and the erase gate. The other regions between the gates are also separated by oxides but they need not be specifically mentioned to describe device operation.

There are two channels, 13 and 15, depicted, which are under the read 7 and program 9 gates, respectively. The channels share the source/drain regions; i.e., the source/drain regions are common to both channels. However, one channel has a read gate and the other channel has a program gate. The channels are thus in different portions of the regions between the source/drain regions. The point of charge injection caused by the program gate 9 into the floating gate 5 is not over the read channel 13. It is over the program channel 15. It was found that for high endurance EEPROMs, i.e., more than 10,000 write/erase cycles, charge trapping in the program or injection oxide becomes important. This is particularly true when the point of charge flow into the floating gate is located over the channel of the EEPROM which is utilized during the read operation.

The structure depicted will be readily fabricated by those skilled in the art using well known fabrication techniques. See, for example, *United States* *Patent 5,036,378* issued on July 30, 1991 to Lu et al. for description of exemplary techniques for making and operating the device. This patent is hereby incorporated by reference.

Comments about advantages of the structure depicted are appropriate. There are separate channels for the control and programming functions as the program and read gates do not share any channel area. Therefore, the read only channel is not degraded by hot carriers injected into the floating gate during the programming operation. However, the carriers injected into the floating gate by the programming gate distribute themselves uniformly within the floating gate because of its high electrical conductivity. These are, therefore, seen by the read gate during operation. Over 1,000,000 write/erase cycles have been obtained under realistic test conditions, i.e., typical operating voltages were used.

There is, of course, a penalty in that additional substrate area is required because of the additional gate structure. Additionally, means for selecting either the read or program channel must be present. This is readily accomplished by those skilled in the art.

Another embodiment is depicted in a top view in FIG. 3. The structure depicted has programming source/drain regions 31 and 33, respectively, and reading source/drain regions 35 and 37, respectively. Regions 33 and 35 are coextensive as depicted. There is also gate 39 which is used for both the program and read functions. There are first and second channels for the reading and programming functions which are between regions 31 and 33 and 35 and 37, respectively. A sectional view along line B-B′ of FIG. 3 is shown in FIG. 4. Fabrication and operation are generally similar to the embodiment described with respect to FIGs. 1 and 2, and further comments are not needed to describe device fabrication and operation.

There are thus first and second channels present. These channels share one source/drain region and a program/read gate. However, the program/read gate uses different portions of the area between source/drain regions 31 and 37 for the programming and reading functions.

For some purposes, the embodiment of FIG. 3 is preferred to that of FIG. 1 because there is a greater overlap of the program/read gate and the floating gate. This leads to a high capacitive coupling ratio between the program/read and floating gates. A high coupling ratio leads to low operating voltages. Variations of the embodiments described will be readily thought of by those skilled in the art. For example, although oxide regions between the gates have been described, other dielectrics, such as nitrides or oxide/nitride composites, may be used. Additionally, the floating gate need not be a split gate. The erase gate may be omitted.

## Claims

1. An EEPROM comprising:
a substrate(e.g. 1);
a floating gate(e.g. 5) comprising an electrically conducting material spaced from said substrate(e.g. 1) by an insulating material(e.g. 23); and
first and second channels(e.g. 13,15) for programming and reading said EEPROM, whereby the point of charge injection into the floating gate(e.g. 5) is not over the read channel(e.g. 13).

2. An EEPROM as recited in claim 1 in which said first and second channels(e.g. 13,15) comprise first and second source/drain regions(e.g. 1,1) and program and read gates(e.g. 9,7), respectively, which utilize different portions of the area between said first and second source/drain regions(e.g. 1,1) for programming and erasing.

3. An EEPROM as recited in claim 1 in which said first and second channels(e.g. 13,15) comprise:
a first source/drain region;
a common program/read gate(e.g. 31,37);
and second and third source/drain regions(e.g. 33,35), said first source/drain region being between said second and third source/drain regions(e.g. 31,37), the areas between said second and first regions(e.g. 31,33) and said first and third regions(e.g. 35,37) being used by said common program/read gate(e.g. 39) for programming and reading, respectively.

4. An EEPROM as recited in claim 1 in which said floating gate(e.g. 5) comprises a split gate.

5. An EEPROM as recited in claim 4 further comprising:
an erase gate(e.g. 11) spaced from said floating gate(e.g. 5) by an insulating material.
